(19) Europäisches Patentamt
European Patent Office
Office européen des brevets

(11) Numéro de publication : **0 186 720**
**B1**

# (12) FASCICULE DE BREVET EUROPÉEN

(45) Date de publication du fascicule du brevet : **17.05.89**

(51) Int. Cl.⁴ : **H 01 L 27/10**, H 01 L 23/52

(21) Numéro de dépôt : **84430049.1**

(22) Date de dépôt : **28.12.84**

## (54) Réseau prédiffusé multifonction en technologie C. Mos.

(43) Date de publication de la demande :
**09.07.86 Bulletin 86/28**

(45) Mention de la délivrance du brevet :
**17.05.89 Bulletin 89/20**

(84) Etats contractants désignés :
**DE FR GB**

(56) Documents cités :
**EP-A- 0 073 641**
**EP-A- 0 080 361**
**EP-A- 0 090 704**
**CUSTOM INTEGRATED CIRCUIT CONFERENCE, 23-25 mai 1983, Rochester, New York, USA; M.A. BROWN et al. "CMOS Cell Arrays - An Alternative to Gate Arrays", pages 74-76**
**WESCON TECHNICAL PAPER, vol. 26, septembre 1982; A. COX et al. "New products from the gate array supermarket", pages 1-11**

(73) Titulaire : **International Business Machines Corporation**
**Old Orchard Road**
**Armonk, N.Y. 10504 (US)**
**DE GB**
**Compagnie IBM FRANCE**
**5 Place Vendôme**
**F-75000 Paris 1er (FR)**
**FR**

(72) Inventeur : **Blachère, Jean-Marie**
**44, av. de l'Orangerie**
**F-91540 Mennecy (FR)**
Inventeur : **Bonneau, Martine**
**5, impasse du Moulin**
**F-91760 Itteville (FR)**
Inventeur : **Hornung, Robert**
**4, rue des Sèvres**
**F-91540 Mennecy (FR)**

(74) Mandataire : **Klein, Daniel Jacques Henri**
**Compagnie IBM France Département de Propriété Intellectuelle**
**F-06610 La Gaude (FR)**

EP 0 186 720 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

**Description**

La présente invention se rapporte à la conception de circuits à très large densité d'intégration (VLSI) et plus particulièrement à une nouvelle configuration optimisée d'une cellule de base pour les réseaux prédiffusés permettant la réalisation de toutes les fonctions logiques simples ou complexes dans la technologie dite des Transistors à Effet de Champ Complémentaires du type Métal Oxide Semi-conducteur (C.MOS FET), dans lesquels le silicium polycristallin remplace le métal.

Les progrès rapides que nous pouvons constater actuellement dans l'amélioration des performances des systèmes informatiques, sont basés dans une très large mesure, sur le développement fulgurant de nouvelles technologies de circuits intégrés à semi conducteurs, qui améliorent en permanence et de façon significative, les caractéristiques de ces circuits et notamment, la densité d'intégration, la puissance dissipée et la vitesse de fonctionnement.

Parmi tous les facteurs qui contribuent à ce développement, la conception physique des circuits est déterminante, en termes de complexité de circuits, de densité d'intégration, de vitesse de fonctionnement, de temps de conception, de facilité de test, etc...

Différentes possibilités s'offrent au concepteur pour placer les composants élémentaires (transistor, ...) à la surface d'une microplaquette de circuits intégrés afin d'obtenir un arrangement de circuits correspondant aux fonctions logiques désirées.

Dans une première approche (dite full custom), les circuits sont réalisés à partir de spécifications et de critères de choix imposé par le client, en raison des besoins particuliers de son application. Dans ce cas, la conception et la réalisation de la configuration de circuits, est longue et coûteuse : dessin de la microplaquette adapté à un seul utilisateur, fabrication de tous les masques, et optimisation maximale au niveau de la densité et de la vitesse qui fait dans la plupart des cas appel à des opérations manuelles. Il faut gérer un nombre considérable de pièces différentes et toute modification impose un redessin complet de tous les masques. Cependant, cette approche est celle qui assure la meilleure exploitation de la surface du silicium et donne le plus de satisfactions à l'utilisateur.

Une autre approche (dite standard cell), utilise des circuits pré-caractérisés. Dans ce cas, les circuits sont créés à partir de fonctions logiques élémentaires décrites dans une librairie. Cette librairie qui peut être très complète assure de très bonnes performances et de très bonnes densités, cependant, l'enrichissement de la librairie se fait manuellement. Un ordinateur génère ensuite tous les masques nécessaires à la fabrication de la microplaquette.

Encore une autre approche, est celle des circuits prédiffusés, qui a été développée à l'origine pour des dispositifs bipolaires sous le nom de tranche maître (master slice). Selon cette approche, toutes les tranches sont traitées de la même façon jusqu'à ce que toutes les étapes de traitement qui concernent le substrat semi-conducteur soient achevées. Seules les étapes finales de métallisation ou étapes de personnalisation sont différentes selon l'application visée. Cette approche s'est révélée être particulièrement bénéfique lorsque la configuration des circuits se prête à une disposition en réseaux (gate array). Un réseau consiste dans un arrangement de cellules élémentaires identiques, disposées à des emplacements prédéterminés selon des rangées et des colonnes. Ces cellules sont constituées par un certain nombre d'éléments actifs (transistors, ...) et passifs (résistances, ...) dont la taille et les caractéristiques ont été définitivement établies pour optimiser certains critères, selon les besoins des utilisateurs. L'interconnexion d'éléments appartenant à une ou plusieurs cellules permet de réaliser le circuit logique remplissant la fonction logique désirée. Le réseau, c'est-à-dire l'agencement des cellules (et donc des éléments) à la surface du silicium, étant connu, des outils de placement et de câblage automatiques peuvent être utilisés avec profit pour assurer les interconnexions désirées. Les données relatives aux masques des niveaux de personnalisation sont fournis par des outils de génération automatique de masques à partir de programmes automatiques de câblage.

Le concept de disposition en réseaux constitue un compromis valable entre l'accroissement de la densité des circuits intégrés à la surface du silicium et les coûts de fabrication. Quelle que soit la technologie, le problème pour le concepteur est de définir la configuration la plus appropriée pour l'obtention des meilleures performances, tout en maintenant une densité d'intégration satisfaisante.

En ce qui concerne cette disposition en réseaux, les paramètres de conception qui gouvernent les performances des circuits logiques standard en technologie CMOS sont :

le rapport géométrique WP/WN, c'est-à-dire le rapport entre la largeur des transistors de type P et de type N qui constituent le réseau en supposant que leur longueur est minimum pour une capacité d'attaque en courant, maximum ;

la largeur cumulative WP + WN de ces transistors ;

la charge capacitive $C_L$ de la porte.

On doit naturellement procéder à des compromis entre les deux premiers paramètres afin d'obtenir un délai déterminé pour une charge donnée et un équilibre optimum entre le « turn on » et le « turn off » du dispositif. Par exemple, si on veut une porte performante avec une capacité de charge élevée, la largeur de la porte WP + WN devient vite prohibitive, et la densité d'intégration décroît rapidement.

En technologie C.MOSFET, un exemple de conception très proche de celle des réseaux prédiffusés, est décrit dans l'article : « CMOS cell arrays — An alternative to gate arrays » by M.A. Brown et al, publié dans les compte-rendus de la Custom Integrated Circuits Conference, qui s'est tenue les 23-25 mai 1983 à Rochester, état de New York, USA.

Selon les enseignements de cette publication (voir Fig. 3), les tranches sont stockées après que les bandes diffusées de type N (pour les FET de type P) et de type P (pour les FET de type N) aient été formées dans chacune des microplaquettes pour former les substrats (ou puits) de ces transistors. Une rangée est constituée par l'association d'une bande diffusée de type N relativement large disposée au-dessus d'une bande diffusée de type P, plus mince, comme cela ressort clairement de la figure 3. Les rangées sont séparées par des voies de câblage. Au moment du stockage, les transistors FET de type P et N ne sont donc pas encore définis. La personnalisation de ces tranches comporte donc, outre les étapes de métallisation proprement dites, l'étape de délimitation de la couche de polysilicium pour laisser les électrodes de porte aux seuls emplacements désirés (voir figure 2).

Par ailleurs, les fonctions logiques simples (ET, OU, ...) ou complexes (registres, ...) sont réalisées sous forme de circuits comprenant un nombre variable de paires de transistors de type P et N. Par exemple, la figure 2 de la publication susmentionnée montre en effet un circuit NR2H à 5 paires de transistors et un circuit INRBH à 3 paires de transistors. En considérant à la limite que ces circuits forment des cellules, c'est d'ailleurs l'appellation qui leur est donnée dans le texte, on peut dire que ces cellules ont une granularité variable, en ce que ce nombre de transistors n'est pas un multiple d'un nombre entier de paires de transistors déterminé a priori.

Enfin, ces cellules sont nécessairement isolées les unes des autres, par des paires, de transistors de type P et N, dits transistors d'isolation, convenablement polarisés comme cela ressort également de la figure 2 ; ces transistors sont donc perdus pour toute utilisation ultérieure dans la construction des fonctions logiques désirées. A noter que des transistors d'isolation sont également utilisés à l'intérieur des circuits en cas de besoin. La figure 1 montre que cette technique d'isolation est cependant très avantageuse quand elle est comparée à la technique classique d'isolement par région d'oxyde encastré, car elle permet un accroissement non négligeable de la densité d'intégration et l'obtention de meilleures performances.

La microplaquette finalement obtenue (voir la figure 4) présente donc d'excellentes caractéristiques notamment en termes de densité d'intégration et de performances, mais souffre cependant d'inconvénients importants qui vont être maintenant discutés.

En premier lieu, le stockage s'effectue trop tôt dans le procédé. En effet, les utilisateurs sont désireux d'obtenir leurs circuits dans les plus brefs délais. Les étapes de personnalisation doivent être réduites à un minimum afin de réduire non seulement les temps de réponse des lignes de fabrication, mais aussi les coûts de fabrication. Selon les enseignements de cette publication, une fois que l'utilisateur a défini ses besoins, il faut déposer une couche globale de polysilicium sur la tranche et la délimiter avant d'implanter les diffusions $N^+$ et $P^+$ qui sont certes des étapes classiques, mais qui retardent cependant la mise à la disposition des microplaquettes à l'utilisateur de réaliser les deux niveaux de métallurgie de la personnalisation proprement dite.

Un autre inconvénient de cette technique est la perte systématique d'une paire de transistors pour isoler deux cellules entre elles.

Par ailleurs, on remarque que ces cellules comportent un nombre variable de paires de transistors, qui ne fait pas apparaître une quelconque granularité.

La réalisation suggérée n'est pas très avantageuse d'un point de vue câblage. Les bandes diffusées de type P et N sont polarisées au deuxième niveau de métallurgie, par des lignes de métallisation perpendiculaires à ces bandes. Les points d'accès aux cellules (I/O pads) ne sont donc accessibles qu'à ce deuxième niveau ajoutant ainsi une contrainte qui n'est pas désirable.

Enfin, cette publication reste muette sur le problème des niveaux de puissance. Des cellules à faible, moyenne, ou forte puissance, peuvent être nécessaires selon les applications. La solution de ce problème, en accord avec les enseignements de cette publication conduirait à réaliser des cellules complexes constituées par la mise en parallèle de cellules élémentaires ; par exemple, une porte ET à 2 entrées de forte puissance, nécessiterait la mise en parallèle de trois portes ET à 2 entrées basse puissance, pas nécessairement adjacentes, et dont l'interconnexion nécessiterait un câblage très important, notamment dans les baies de câblage.

On trouve également dans la référence EP-A-8205424.2 la description d'une construction de circuits en technologie CMOSFET à granularité variable, selon laquelle les circuits sont isolés les uns des autres par des transistors d'isolation. On trouve enfin dans la référence EP-A-82306212.0, la description d'un arrangement de transistors CMOS FET, selon deux bandes disposées l'une au-dessus de l'autre, l'une contenant les transistors de type P et l'autre les transistors de type N, dans lesquelles les paires de transistors appairés sont disposées de façon répétitive, les unes à côté des autres, sans la présence des habituelles zones d'isolation en matériau diélectrique couramment utilisées jusqu'alors. Dans le dernier cas, la granularité de la cellule de base est d'une paire de transistors complémentaires.

La présente invention, telle que revendiquée dans la partie caractérisante de la revendication 1 et qui concerne essentiellement une nouvelle configuration de cellule pour réseaux prédiffusés en technologie CMOS avec au moins deux niveaux de métallisation, a pour but de remédier à tous ces inconvénients.

Un premier objectif de l'invention est donc de fournir une configuration de cellule qui permette le stockage de la tranche préalablement aux seules étapes de personnalisation (ouverture des contacts et métallisation) proprement dites.

Un autre objectif de l'invention est de fournir une configuration de cellule qui minimisant les résistances et capacités parasites, d'une part limite la largeur ($W_P + W_N$) et donc, la hauteur de la cellule, et d'autre part donne une plus grande souplesse dans la réalisation du câblage interne de la cellule. Cette configuration permet de réaliser tous les circuits avec trois niveaux de puissance différents, afin de les adapter à leur charge, sans réduction de la densité d'intégration et sans nécessiter de câblage dans les baies de câblage.

Encore un autre objectif de l'invention est de fournir une configuration de cellule qui évite le recours systématique aux transistors d'isolation pour assurer l'isolement entre deux circuits, permettant un gain appréciable en termes d'accroissement de la densité d'intégration et de la réduction des éléments parasites.

Encore un autre objectif de l'invention est de fournir une configuration de cellule qui présente une granularité constante.

Ces objectifs sont atteints en particulier grâce à une conception nouvelle de la configuration d'une cellule de base qui permet la génération d'une librairie de circuits qui seront obtenus par l'association de plusieurs de ces cellules de base.

Les tranches sont stockées, après que les électrodes de porte des transistors de type P et N aient été formées (ce qui a pour résultat de définir lesdits transistors) et que la surface de la tranche ait été passivée par une couche de matériau diélectrique. Les électrodes de porte d'une paire de transistors de type P et N, sont alignées comme dans la publication précitée, mais ne sont pas reliées.

Ensuite, la demanderesse définit la configuration d'une cellule de base, contenant un nombre déterminé et constant, de paires de transistors, dont la taille et la disposition seront définitivement établies, pour optimiser certains critères qui seront explicités ci-après. En d'autres termes, la granularité de la cellule sera constante. Tout circuit logique sera réalisé à partir d'une ou plusieurs cellules identiques et les interconnexions internes et entre cellules seront faites lors de la personnalisation.

Pour la détermination du nombre optimum de paires de transistors de type P et de type N que doit comporter une cellule, la demanderesse a fait les hypothèses suivantes : la largeur de la cellule doit être un multiple entier N de la valeur du pas PM2 de la grille de métallisation verticale du second niveau ; minimiser les longueurs de diffusion consiste à trouver le nombre entier M du pas intra-cellulaire PPoly des électrodes de portes en polysilicium, qui donne une valeur positive, mais minimum, à la différence N*PM2—M* PPoly. Pour les technologies actuelles, les meilleurs résultats ont été obtenus pour M = 3 (c'est-à-dire 3 paires de transistors) et N = 4 (c'est-à-dire 4 pistes de câblage dans le sens vertical) pour une cellule. Il faut en outre noter qu'une cellule de faible granularité, améliore la densité d'intégration, car on ne perd tout au plus, que 2 paires de transistors par circuit logique.

Une caractéristique importante de l'invention est que pour chaque circuit simple ou complexe, on établit la règle de frontière suivante : la première et la dernière diffusions du circuit sont respectivement portées à la masse GD (source d'un transistor N) et à la tension d'alimentation VH (source d'un transistor P). Cette règle de frontière permet un assemblage aisé des différents circuits pour former les rangées, et évitera dans une grande mesure la nécessité de placer systématiquement des transistors d'isolation entre deux circuits. Les transistors d'isolation tels qu'ils sont utilisés dans la publication précitée peuvent continuer à être utilisés à l'intérieur d'un circuit en cas de besoin, mais ne le sont plus systématiquement pour séparer deux circuits entre eux.

Il en résulte finalement un gain de place appréciable.

Enfin, l'approche de la demanderesse d'une part, résout le problème des trois niveaux de puissance par circuit ou porte logique, qui sont généralement souhaités pour adapter la fonction logique à sa charge, c'est-à-dire d'obtenir les délais qui sont les plus adaptés à la charge de sortie. L'utilisateur possède une librairie plus riche qui avec l'aide d'outils de simulation de délai, lui permet de choisir au mieux, le niveau de puissance le plus approprié pour une chaîne de circuits logiques. La plus grande facilité est laissée au concepteur dans la mise de transistors en parallèle à l'intérieur d'un même circuit, grâce à la possibilité d'avoir des points d'accès pour les circuits au premier niveau de métallurgie ; il en résulte que ces circuits de puissance sont réalisés, sans qu'il soit besoin d'utiliser les baies de câblage pour leur interconnexion.

D'autres objectifs, caractéristiques et avantages de la présente invention ressortiront mieux de l'exposé qui suit, fait en référence aux dessins annexés à ce texte qui représentent un mode de réalisation préféré de celle-ci.

La figure 1 représente une vue de dessus très schématique de la topologie d'une microplaquette conforme à la présente invention.

La figure 2 représente une portion agrandie de cette topologie, montrant la disposition tête-bêche des cellules dans une même rangée.

La figure 3A représente une vue partielle d'une demi-rangée de transistors P et N avant personnalisation qui met en évidence sa granularité d'une cellule (les bus de masse GD et d'alimentation VH ont cependant été également représentés).

La figure 3B en donne le schéma électrique équivalent.

La figure 4A représente la topologie d'un circuit inverseur utilisant une cellule unique et son câblage des transistors.

La figure 4B représente le schéma électrique équivalent de l'inverseur montré sur la figure 4A.

La figure 5A représente la topologie après câblage, d'un circuit ET à deux entrées et d'un circuit ET à 3 entrées adjacentes qui ne nécessite pas de transistors d'isolation entre eux.

La figure 5B représente le schéma électrique équivalent des circuits montrés sur la figure 5A.

La figure 6A représente la topologie après câblage, d'un circuit NON-ET à 3 entrées.

La figure 6B représente le schéma électrique équivalent du circuit montré sur la figure 6A.

Les figures 7A, 7B et 7C montrent les différentes topologies après câblage d'un circuit NON-ET à 2 entrées et ces schémas électriques équivalents correspondants selon que le niveau de puissance est respectivement faible, moyen et fort.

La figure 1 représente une vue de dessus, très schématique de la topologie d'une microplaquette de silicium 10 (de 6,9 x 7,1 $mm^2$) conforme à la présente invention. Cette topologie obéit au concept de tranche mère et met en évidence l'organisation de sa surface en réseau.

Les circuits d'entrée-sortie 11 qui sont disposés à la périphérie de la microplaquette contiennent les émetteurs-récepteurs pour la transmission des signaux entre la microplaquette et le monde extérieur. Des circuits d'entrée/sortie appropriés sont connus dans l'état de la technique et ne font pas partie de la présente invention.

Le réseau proprement dit, montré sur la figure 1, comporte au maximum environ 6 000 cellules internes 12 alignées suivant des rangées 13. une partie de ces cellules peut être remplacée de façon connue par des macro, par exemple des mémoires de type RAM comme cela est représenté sur la figure 1. Ces dernières sont accolées deux par deux pour former des rangées doubles, à l'exception de 4 rangées simples. Cette disposition en rangées est considérée comme classique et ne fait pas partie de l'invention, elle est cependant fournie aux fins d'illustration de cette dernière. Dans les rangées doubles, les cellules sont habituellement placées tête-bêche, de sorte qu'un seul bus transportant la tension d'alimentation VH, est suffisant pour polariser deux rangées de cellules. Des baies de câblage 14 sont laissées entre les rangées, elles seront empruntées par les conducteurs d'interconnexion du premier niveau de métallisation (M1). Des conducteurs largement dimensionnés transportant les tensions d'alimentation VH et de masse GD, sont disposés dans la baie centrale 15, et à partir de là, assurent la polarisation des cellules, par des fils horizontaux ou bus, également formés avec le premier niveau de métallisation.

La figure 2 détaille la petite portion de la topologie de la microplaquette qui est référencée en 16 sur la figure 1 qui met en évidence la disposition tête-bêche des cellules 12. Bien que non encore formés au moment du stockage, les bus d'alimentation et de masse VH et GD ont été représentés avec des hachures. Il est évident que la configuration générale de la microplaquette 10 telle qu'elle est représentée schématiquement sur les figures 1 et 2 est connue dans son principe. Comme on l'expliquera plus en détail ci-après, la nouveauté de la présente invention réside principalement dans la configuration de la cellule 12 et sa granularité. Bien que classiques, les principales étapes du procédé de fabrication d'une telle microplaquette vont être maintenant décrites brièvement, à travers les masques de lithographie correspondants pour permettre une meilleure compréhension de la description de la présente invention qui va suivre.

Le masque RX : il permet de définir des poches de silicium monocristallin (où seront formés ultérieurement les transistors FET de type P et N), isolées par des régions d'oxyde encastré.

Le masque NW : on forme par implantation ionique d'arsenic des « puits » de type N où seront formés les transistors FET de type P.

Le masque BF permet la formation par implantation ionique d'ions bore d'une poche dans le substrat (évite les fuites possibles des transistors N et P).

Le masque P1 : après un dépôt global d'une couche de polysilicum, celle-ci est délimitée pour ne laisser que les électrodes de porte des transistors FET.

Le masque BP : c'est un masque de blocage qui protège les zones qui ne doivent pas recevoir des dopants de type N, c'est-à-dire les transistors de type P. L'implantation d'ions arsenic forme les régions source et drain des transistors FET de type N, et sont autoalignées avec l'électrode de porte en polysilicium correspondante.

Le masque BN : complémentaire du masque BP, c'est un masque de blocage qui protège les zones qui ne doivent pas recevoir des dopants de type P.

Les étapes de personnalisation font appel essentiellement à quatre masques :

le masque CA : pour pratiquer des ouvertures dans la couche de passivation et définir les zones de contact ohmique sur les électrodes de porte, les régions de source et de drain, de polarisation du substrat et des « puits » ;

le masque M1 : pour délimiter la configuration du premier niveau de métallisation qui comprend d'une part des lignes de métallisation (ou conducteurs) préfixées : une ligne dans la voie de câblage pour la polarisation du substrat et les lignes de métallisation formant les bus GD et VH représentés sur la figure 2 et d'autre part, le câblage interne de chaque circuit qui s'effectue selon une grille, les ouvertures pratiquées avec le masque CA se trouvant aux points d'intersection de cette grille et, des lignes de métallisation dans les voies de câblage permettent le câblage global (de circuit à circuit) ;

le masque NV : permet la réalisation des trous de traversée dans la première couche d'isolation de nitrure qui sépare les premier et deuxième niveaux de métallisation ;

le masque PV : permet la réalisation des trous de traversée dans la deuxième couche d'isolation de polymide qui sépare les premier et deuxième niveaux de métallisation ;

le masque M2 : définit uniquement au deuxième niveau de métallisation, des lignes de métallisation préfixées relativement larges dans la voie centrale 15 pour le transport des tensions d'alimentation et de masse et des lignes de métallisation selon le sens vertical d'une deuxième grille appelée grille de câblage global. Les points de contacts entre les premier et deuxième niveaux de métallisation sont respectivement référencés LST, pour les points d'accès (I/O) aux fonctions logiques et vias, pour les points de contacts situés dans les baies de câblage.

La figure 3A représente une portion d'une rangée 13 simple, mettant en évidence la configuration de la présente invention au moment du stockage de la tranche, c'est-à-dire avant la personnalisation. On a cependant représenté avec des hachures les bus d'alimentation VH et de masse GD bien qu'ils ne soient pas présents à ce niveau du procédé de fabrication. Dans sa philosophie générale cette configuration reprend les principes de la configuration de l'art antérieur mentionné ci-dessus, en ce qui concerne la disposition des transistors de type P et des transistors de type N montés en série, du bus d'alimentation VH et du bus de masse GD. La figure 3B qui montre le schéma électrique équivalent de la configuration montrée sur la figure 3A, met bien en évidence le montage série des transistors de type P et N. La technique d'isolement des cellules par des transistors d'isolation convenablement polarisés, qui autorise une plus grande densité d'intégration, est également reprise ici dans son principe tout en restant limitée dans son application comme on le verra plus loin. Cependant les figures 3A et 3B ne permettent pas de mettre en évidence les transistors d'isolation, puisque à ce niveau du procédé (avant la personnalisation), tous les transistors N (ou P) sont identiques. En outre, sur ces figures, on a fait ressortir le rôle des principaux masques tels que définis ci-dessus.

Mais parce qu'elle vise des performances supérieures, à celles des cellules connues de l'art antérieur, des améliorations et changements significatifs ont été apportés à sa conception qui vont maintenant être décrits plus en détail.

Tout d'abord on remarque sur les figures 3A et 3B que les électrodes de portes en polysilicium (G1, G'1, ...) de toutes les paires de transistors de type N et P (T1, T'1, ...) sont alignées, mais qu'elles ne sont pas reliées entre elles. Comme on l'a vu ci-dessus, c'est le masque P1 qui définit les électrodes de portes. Les tranches sont donc stockées avant les étapes de personnalisation proprement dites (masques CA, M1, NV et M2). La couche de polysilicium étant déjà délimitée au moment du stockage, il est évident que la personnalisation ne nécessite que des étapes de dépôt de couches diélectriques, de formation d'ouvertures et de délimitation de la métallurgie, qui sont classiques et peuvent être réalisées rapidement (2 semaines). C'est un premier point important de l'invention.

Ensuite les différents critères d'optimisation à prendre en compte sont les suivants :

La longueur de canal doit être minimale, compte tenu des possibilités de la technologie utilisée pour bénéficier du courant maximal possible pour charger et décharger la capacité de charge en sortie $C_L$.

Le rapport $W_P/W_n$ des largeurs des transistors de type P et N doit être choisi pour minimiser le délai moyen de l'ensemble des circuits. Augmenter ce rapport favorise la charge de la capacité de sortie sachant qu'un circuit NAND favorise la charge et un circuit NOR favorise la décharge, il faut donc établir un compromis puisque tous les transistors de type P et de type N ont la même taille.

La somme $W_P + W_N$ doit être déterminée pour assurer un compromis acceptable entre les performances en délai et la surface occupée du substrat. Elle doit aussi présenter un nombre de pistes de câblage suffisant pour permettre l'interconnection des cellules constituant un circuit et ce pour l'ensemble de la librairie de circuits. On a montré que les variations du gain de délai diminuent à partir d'une certaine valeur pour $W_P + W_N$. La courbe $(W_P + W_N)$ fonction du délai est en effet asymptotique.

La largeur des diffusions correspond au minimum nécessaire au passage d'un fil de connexion. On augmente ainsi la densité d'intégration et on diminue les capacités de diffusion. Par ailleurs, pour tirer bénéfice de l'utilisation des transistors d'isolation, il est nécessaire que les largeurs de diffusion entre les électrodes de porte en polysilicium soient proches de leur valeur minimum.

Il faut donc trouver le nombre optimum de paires de transistors de type P et N dans une cellule. En posant que la largeur de la cellule doit être un nombre entier N de fois, celle du pas PM2 de la grille verticale du second niveau de métallisation, minimiser les longueurs de diffusion, consiste donc à trouver le nombre entier M de fois du pas intercellulaire PPoly qui fournit une valeur minimum mais positive à la différence N*PM2 — M*PPoly. La signification physique des pas PM2 et PPoly est donnée sur la figure 3A. Avec la technologie mise en oeuvre par la demanderesse, on a démontré expérimentalement que les meilleurs résultats étaient obtenus pour M = 3 (soit trois paires de transistors) et N = 4 (soit quatre canaux de câblage vertical) par cellule.

En effet dans cette technologie on a relevé les valeurs suivantes : PPoly = 9,5 µm, PM2 = 7,2 µm, on a recherché les nombres M et N tels que la différence D = N*PM2 — M*PPoly soit minimum tout en restant positive. On se rend compte qu'avec M = 3 et N = 4, on trouve M*PPoly = 28,5 µm et N*PM2 = 28,8 µm d'où D = 0,3 qui apparaît être une bonne solution au problème.

Avec ces valeurs, on a noté que l'augmentation des largeurs de diffusion (qui commandent la largeur de la cellule et donc la densité d'intégration) est seulement de 5 % supérieure à sa valeur minimum. La figure 3A montre la topologie et la granularité d'une cellule 12 et la figure 3B montre le schéma électrique équivalent.

Le second point important de l'invention est donc le choix d'une granularité de 3 paires de transistors de type N et P (T1, T'1, ..., T3, T'3), pour constituer la cellule de base 12. Ainsi chaque cellule 12, montrée sur la figure 1, est en fait constituée par trois paires de transistors de type N et P (T1) dont les électrodes de porte (G1, G'1) d'une paire de transistors appairés (T1, T'1) ne sont pas reliées. Cette disposition est très avantageuse dans la réalisation de circuits logiques autres que ceux de la logique combinatoire, dans lesquels les électrodes de porte des transistors, ne sont que rarement reliées entre elles, par exemple, les registres qui constituent jusqu'à 40 % de la surface des microplaquettes en raison de leur utilisation intensive. Cette disposition est également très utile dans les circuits comportant des portes de transfert. Enfin, le concepteur peut utiliser l'un des transistors appairés, comme transistor d'isolation dans un circuit déterminé, l'autre restant fonctionnel et non pas la paire de transistors toute entière.

Encore un autre point important de l'invention est que tout circuit logique de la librairie est obligatoirement construit à partir d'un nombre entier de fois la cellule de base, et comprendra donc un nombre de paires de transistors qui sera nécessairement un multiple de trois.

Sur la figure 4A, on a représenté une cellule câblée pour former un circuit inverseur, dont le schéma électrique équivalent est donné sur la figure 4B. Cet inverseur constitue le circuit le plus simple de la librairie car il est constitué par une cellule unique. Ce circuit est montré aux seules fins d'une illustration simplifiée de l'invention car il ne met pas en évidence tous les avantages de l'invention. Un inverseur simple se composant seulement d'une paire de transistors P et N, l'utilisation de la cellule à 3 paires implique nécessairement dans ce cas la perte de 2 paires de transistors. On a représenté sur la figure 4A, d'une part, la grille de câblage global, et d'autre part, la grille de câblage interne. Au premier niveau de métallisation (selon la grille de câblage interne), on trouve 6 pistes de câblage verticales et 15 pistes de câblage horizontales. Parmi ces dernières, 10 seront effectivement utilisées entre les bus VH et GD au-dessus d'une cellule. On s'est rendu compte dans le cadre de la présente invention, que tout circuit y compris le plus complexe pouvait être câblé avec 10 pistes.

Il y a 6 pistes de câblage verticales parce qu'il y a 3 électrodes de porte et trois régions de diffusion (source/drain) à câbler pour chaque cellule.

Au second niveau de métallisation (selon une grille dite de câblage global), on trouve 4 pistes de câblage verticales (au pas PM2) et 22 pistes de câblage horizontales. Ces dernières, à l'intersection avec les 4 pistes verticales permettent le positionnement des LST. Les fils de câblage du premier niveau de métallurgie sont interdits dès lors qu'ils passeraient à proximité des LST, mais restent autorisés dans les rues de câblage.

La présence de ces grilles de câblage interne et global, est particulièrement avantageuse quand des programmes informatiques de conception et de câblage automatiques sont utilisés.

Un autre point important de l'invention, qui ressort de la figure 4A, est que l'on s'impose de mettre les premières (S1, S'1) et les dernières (D3, D'3) régions de diffusion (source/drain) du circuit inverseur, respectivement, au potentiel GD pour les transistors N et, au potentiel VH pour les transistors P.

La région de source S1 du transistor T1 est mise au potentiel de la masse GD par les contacts 40 et 40' tandis que la région de source S'1 du transistor T'1 est mise au potentiel VH par les contacts 41 et 41'.

De même, la région de drain D3 du transistor T3 est mise au potentiel de la masse par les contacts 42 et 41', tandis que la région de drain D'3 du transistor T'3 est mise au potentiel VH par les contacts 43 et 43'.

Tous les circuits logiques conformes à la présente invention comporteront donc de 1 à P cellules de base (P étant un nombre entier quelconque), pour chaque circuit, la première et la dernière régions de diffusion sont mises au potentiel de la masse GD pour ce qui concerne les transistors de type N et au potentiel VH en ce qui concerne les transistors de type P. Cette règle de frontière est impérative. Lors de la conception physique d'un nouveau circuit remplissant une fonction logique déterminée, le concepteur de circuit s'assure que cette règle est bien appliquée avant de poursuivre le dessin du circuit.

L'avantage est que pour un circuit déterminé, les dernières diffusions pourront être mises en commun avec les premières diffusions correspondantes du circuit qui lui est directement adjacent. Il en résulte que lorsque cela est possible, deux circuits peuvent être placés adjacents, sans pour autant nécessiter la mise en place de transistors d'isolation. D'où un gain de place et une réduction des longueurs de connexion entre deux circuits adjacents.

Un autre avantage est que l'on peut introduire un circuit à un emplacement quelconque d'une rangée de circuits, sans précaution particulière, ce qui permet un gain en silicium et apporte une grande facilité pour l'utilisateur.

Comme cela apparaît sur les figures 4A et 4B, l'électrode de porte G1 du transistor T1 de type N est également reliée au bus de masse GD par un fil disposé entre les contacts 40 et 44, tandis que l'électrode de porte G'1, du transistor T'1 de type P qui lui est appairé, est reliée au bus par un fil disposé entre les contacts 41 et 45 (à noter qu'entre ces contacts 41 et 45, d'autres contacts sont réalisés entre la région de source S'1 et le fil de métallisation pour réduire les résistances de contact). Il en est de même pour la paire de transistors T3 et T'3. Les transistors T1 et T'1 (T3 et T'3), sont des transistors d'isolation pour ce circuit. Le circuit inverseur représenté sur les figures 4A et 4B n'utilise fonctionnellement qu'une paire de transistors, les deux autres paires ne sont pas utilisées et sont donc montées en transistors d'isolation. Les contacts référencés 46 représentent les contacts pour polariser le puits de diffusion de type N qui contient les transistors de type P, au potentiel VH.

On remarquera enfin la disposition particulière du bus GD qui chevauche l'extrémité 47 des électrodes de portes des transistors de type N. Cette extrémité est élargie et n'est recouverte qu'à moitié par le bus GD. Cette disposition est avantageuse en ce qu'elle permet à toute électrode de porte d'être soit disponible pour un contact d'entrée/sortie (par exemple, le contact IN de l'électrode de porte G2 à travers le contact 48) soit d'être directement reliée au potentiel GD (par exemple : l'électrode de porte G3 à travers le contact 49).

Ceci est particulièrement important pour les transistors d'isolation de type N car l'électrode de porte est directement reliée à la masse par un contact. En outre cette disposition augmente dans de grandes proportions la câblabilité des fonctions logiques car elle permet de laisser libre le passage au-dessus des diffusions de type N sans pour autant augmenter la hauteur de la cellule. Il n'est pas possible de réaliser une disposition identique pour les transistors de type P, en raison de la polarisation au VH du puits de type N. L'inconvénient est minime, car s'il existe uniquement 3 passages horizontaux possibles pour les pistes au-dessus des transistors N, il y en a 5 au-dessus de transistors P (voir la figure 4A).

Comme cela a été rapporté plus haut, cet exemple ne met pas en valeur tous les avantages de la présente invention, mais a le mérite d'en permettre une compréhension plus facile.

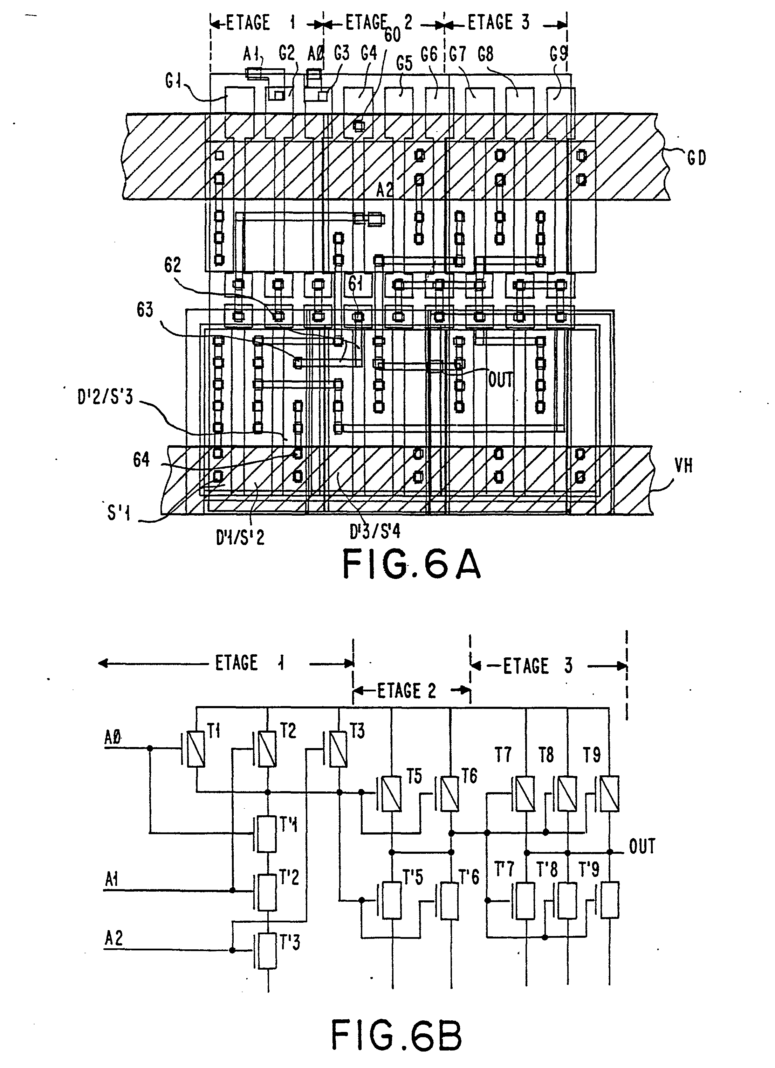

Les avantages vont être mieux compris à l'aide des figures 5A, 5B et 6A, 6B qui vont être maintenant détaillées.

Sur la figure 5A, on a représenté deux circuits : un ET à 2 entrées 50 et un ET à 3 entrées 51 qui sont disposés adjacents pour autant sans nécessiter la présence de transistors d'isolation entre eux.

Chaque circuit est constitué par deux cellules de trois paires de transistors. Le schéma équivalent électrique est représenté sur la figure 5B. Conformément à ce qui a été dit plus haut, les première et dernière diffusions des transistors de type N (S1, D12) et des transistors de type P (S'1, D'12) sont respectivement reliées aux potentiels GD et VH.

La région de drain D6 du transistor T6 est mise en commun avec la région de source S7 du transistor T7. Cette région commune D6/S7 est portée au potentiel de la masse GD par les contacts 52.

De même, la région commune D'6/S'7 est portée au potentiel de l'alimentation VH par les contacts 53. On a donc contrairement au mode de réalisation montré dans la publication précitée, 2 circuits différents, accolés sans la présence de transistors d'isolation.

La figure 6A représente la topologie d'un circuit NON-ET à 3 entrées dont la figure 6B montre le schéma électrique équivalent. D'après cette dernière figure 6B, on se rend compte que ce circuit est constitué par 3 étages, au total 8 paires de transistors. Ce circuit est réalisé en pratique par la combinaison de 3 cellules de base, soit 9 paires de transistors ; 1 paire de transistors (T4, T'4) est donc perdue. Les deux transistors de cette paire sont polarisés comme des transistors d'isolation. Le circuit représenté sur la figure 6A présente la particularité d'avoir les étages 2 et 3 échangés dans la topologie du circuit. Cette disposition est rendue possible, parce que l'on peut mettre en commun d'une part, les premières diffusions (S4, S'4) de l'étage 3 avec les dernières diffusions (D3, D'3) de l'étage 1, (et d'autre part les dernières diffusions (D6, D'6) de l'étage 3 avec les premières diffusions (S7, S'7) de l'étage 2. Cette facilité qui est laissée au concepteur de circuit doit être utilisée chaque fois qu'elle est possible pour accroître la densité d'intégration de la microplaquette.

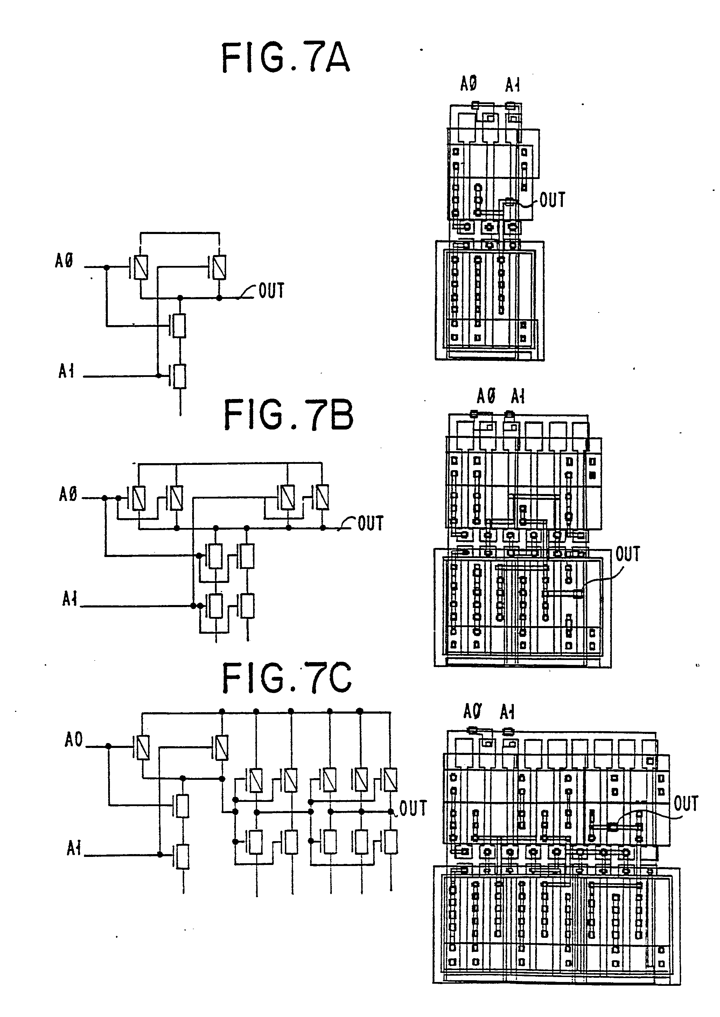

Les figures 7A, 7B et 7C montrent comment le problème de l'adaptation des circuits logiques à leur charge peut être résolu dans le cas d'une porte NON-ET à 2 entrées. Les figures 7A, 7B et 7C représentent respectivement les trois niveaux de puissance qui sont proposés à l'utilisateur : faible, moyen et fort. On peut se rendre compte sur ces figures, que les cellules sont câblées uniquement avec le câblage interne.

## Revendications

1. Réseau prédiffusé multifonction formé dans des tranches de silicium selon la technologie CMOS à électrodes de porte en polysilicum et au moins deux niveaux de métallisation, du genre comportant une pluralité de rangées (13) séparées par des voies de câblage (14) ; ce réseau étant caractérisé en ce que :

chaque rangée comprend une pluralité de circuits logiques adjacents non isolés les uns des autres par des transistors d'isolation ; chaque circuit logique est lui-même composé d'un nombre entier de fois une cellule de base (12) dont la granularité constante M, définie par le nombre entier de paires de transistors contenus dans la cellule, est telle que l'expression N*PM2-M*PPoly, dans laquelle N est un nombre entier, PPoly le pas intracellulaire des électrodes de porte en polysilicium et PM2, le pas de la grille de métallisation du second niveau, soit minimum tout en restant positive ; et en ce que les première et dernière régions de diffusion, qui remplissent les fonctions de source ou de drain, de chaque circuit sont au potentiel de la masse (GD) en ce qui concerne les transistors de type N et au potentiel de l'alimentation (VH) en ce qui concerne les transistors de type P.

2. Réseau selon la revendication 1 caractérisé en ce que lesdites électrodes de porte ont été délimitées préalablement, à la personnalisation, les électrodes de porte d'une paire de transistors N et P appairés n'étant pas reliées entre elles.

3. Réseau selon la revendication 1 ou 2 caractérisé en ce que la granularité de chaque cellule est de 3, c'est-à-dire M = 3 et N = 4.

4. Réseau selon la revendication 3 caractérisé en ce que la grille de métallisation au premier niveau dite de câblage interne comprend pour chaque cellule, des conducteurs alignés d'une part sur 6 pistes de câblage verticales et d'autre part sur 15 pistes de câblage horizontales, ainsi que les conducteurs horizontaux correspondant aux bus de masse (GD) et d'alimentation (VH).

5. Réseau selon la revendication 4 caractérisé en ce que sur les 16 pistes de câblage horizontales 10 sont effectivement utilisées entre lesdits bus de masse et d'alimentation dont 3 sont disposées au-dessus des transistors, de type N et 5 au-dessus des transistors de type P.

6. Réseau selon l'une des revendications 3 à 5 caractérisé en ce que la grille de métallisation au deuxième niveau dite de câblage global comprend pour chaque cellule des conducteurs alignés d'une part sur 4 pistes de câblage verticales (au pas PM2) et 22 pistes de câblage horizontales.

7. Réseau selon la revendication 6 caractérisé en ce que les points d'accès aux fonctions logiques (entrées/sorties) ou LST, ne se trouvent qu'à l'intersection desdites 4 pistes de câblage verticales et desdites 22 pistes de câblage horizontales du deuxième niveau de métallisation.

8. Réseau selon l'une des revendications ci-dessus caractérisé en ce que le bus de masse (GD) chevauche une extrémité élargie des électrodes de porte des transistors de type N.

## Claims

1. A multifunction pre-diffused array formed in silicon wafers by means of the CMOS technology and provided with polysilicon gate electrodes and at least two levels of metallization, of the type comprising a plurality of rows (13) separated by wiring bays (14), said array being characterized in that :

each row includes a plurality of adjacent logic circuits that are not isolated from one another by isolation transistors ; each logic circuit is comprised of a whole number of basic cells (12) the constant granularity M of which, as defined by the whole number of pairs of transistors contained in the cell, is such that the expression N*PM2-M*PPoly, where N is an integer, PPoly is the intra-cell pitch of the polysilicon gate electrodes, and PM2 is the pitch of the second level metallization grid, will take on a minimum yet positive value ; and the first and last diffusion regions, which function as either source or drain, in each circuit are at ground potential (GD) in the case of N-channel transistors and at the supply potential (VH) in the case of P-channel transistors.

2. An array according to claim 1, characterized in that said gate electrodes have been delimited prior to customization, with no interconnection of the gate electrodes of a couple of paired N-channel and P-channel transistors.

3. An array according to claim 1 or 2, characterized in that each cell has a granularity of 3, that is, M = 3 and N = 4.

4. An array according to claim 3, characterized in that the first level metallization grid, termed internal wiring grid, includes, for each cell, conductors aligned, on the one hand, with 6 vertical wiring tracks and, on the other hand, with 15 horizontal wiring tracks, together with the horizontal conductors corresponding to the ground (GD) and supply (VH) busses.

5. An array according to claim 4, characterized in that 10 out of the 15 horizontal wiring tracks are actually used between said ground and supply busses, 3 of said 10 tracks being disposed over N-channel transistors and 5 of said 10 tracks being disposed over P-channel transistors.

6. An array according to any one of claims 3 to 5, characterized in that the second level metallization grid, termed global wiring grid, includes, for each cell, conductors aligned, on the one hand, with 4 vertical wiring tracks (using pitch PM2) and, on the other hand, with 22 horizontal wiring tracks.

7. An array according to claim 6, characterized in that access points to logic functions (inputs/outputs), or LSTs, are only provided at the intersections of said 4 vertical wiring tracks and said 22 horizontal wiring tracks in the second level of metallization.

8. An array according to any one of the preceding claims, characterized in that the ground (GD) bus lies over an enlarged end of the gate electrodes of N-channel transistors.

## Patentansprüche

1. In Siliziumscheiben entsprechend der CMOS-Technologie ausgestaltetes vordiffundiertes Multifunktionsnetzwerk mit Gatterelektroden aus Polysilizium und mindestens zwei Metallisierungsniveaus, von der Art, welche eine Vielzahl von durch Verdrahtungsbahnen (14) getrennten Reihen (13) enthält ; wobei das Netzwerk dadurch gekennzeichnet ist, dass :

Jede Reihe eine Vielzahl von nebeneinanderliegenden, untereinander nicht durch Isolationstransistoren isolierten logischen Schaltkreisen enthält ; jeder logische Schaltkreis besteht seinerseits aus einem ganzzahligen Mehrfachen von einer Grundzelle (12), deren konstante, durch die ganzzahligen, in der Zelle enthaltenen Transistorpaare definierte Körnung derart ist, dass der Ausdruck N*PM2-M*PPoly, worin N eine ganzzahlige Grösse, PPoly der intrazelluläre Raster der Gatterelektroden aus Polysilizium und PM2 der Raster des Metallisierungsgitters des zweiten Niveaus ist, obgleich positiv bleibend, ein Minimum ist ; und dadurch, dass der erste und letzte, die Funktionen von Source und Drain ausübende Diffusionsbereich für die Transistoren vom N-Typ am Massepotential (GD) und für die Transistoren vom P-Typ am Stromversorgungspotential (VH) liegen.

2. Netzwerk nach Anspruch 1, dadurch gekennzeichnet, dass die Gatterelektroden zuvor bei der Personalisierung eingegrenzt wurden, während die Gatterelektroden eines gepaarten N- und P-Transistorpaars untereinander nicht verbunden sind.

3. Netzwerk nach Anspruch 1 oder 2, dadurch gekennzeichnet, dass die Körnung jeder Zelle 3 ist, d. h. M = 3 und N = 4.

4. Netzwerk nach Anspruch 3, dadurch gekennzeichnet, dass das Metallisierungsgitter im ersten Niveau, das sogenannte Innenverdrahtungsgitter, für jede Zelle einerseits auf 6 vertikalen Verdrahtungsbahnen und andererseits auf 15 horizontalen Verdrahtungsbahnen ausgerichtete Leiter sowie die den Massebussen (GD) und der Stromversorgung (VH) entsprechenden Leiter enthält.

5. Netzwerk nach Anspruch 4, dadurch gekennzeichnet, dass von den 16 horizontalen Verdrahtungsbahnen zehn effektiv zwischen den Massebussen und der Stromversorgung eingesetzt werden, von denen 3 über den Transistoren vom Typ N und 5 über den Transistoren vom Typ P angeordnet sind.

6. Netzwerk nach einem der Ansprüche 3 bis 5, dadurch gekennzeichnet, dass das Metallisierungsgitter im zweiten Niveau, das sogenannte Gesamtverdrahtungsgitter, für jede Zelle der ausgerichteten Leiter einerseits 4 senkrechte Verdrahtungsbahnen (mit dem Raster PM2) und 22 horizontale Verdrahtungsbahnen enthält.

7. Netzwerk nach Anspruch 6, dadurch gekennzeichnet, dass die Zugangspunkte zu den logischen Funktionen (Ausgänge/Eingänge) oder LST, sich nur am Schnittpunkt der 4 vertikalen und der 22 horizontalen Verdrahtungsbahnen des zweiten Metallisierungsniveaus befinden.

8. Netzwerk nach einem der vorangehenden Ansprüche, dadurch gekennzeichnet, dass der Massebus (GD) ein verbreitertes Ende der Gatterelektroden der Transistoren vom N-Typ überschneidet.

FIG. 1

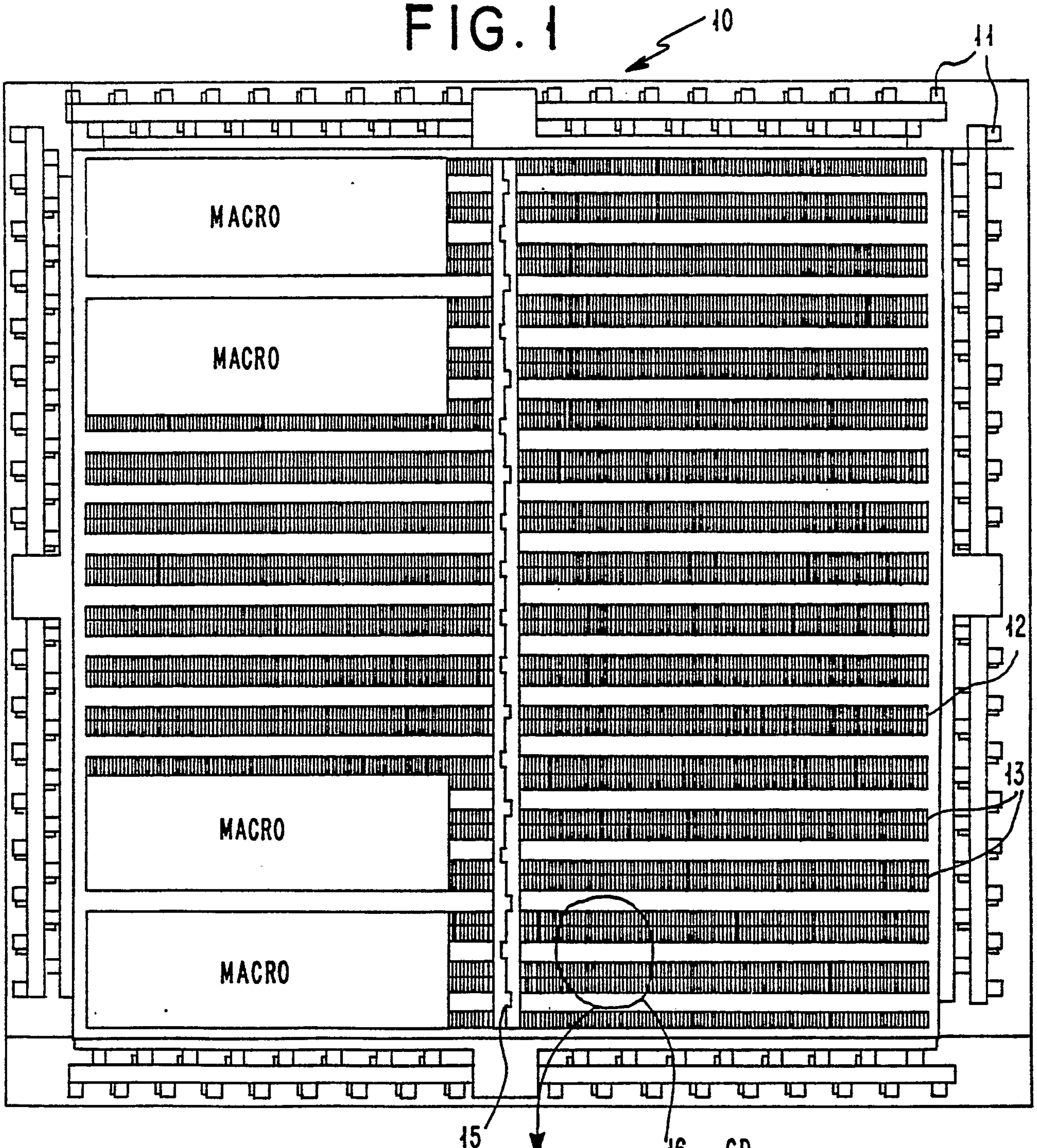


FIG. 2

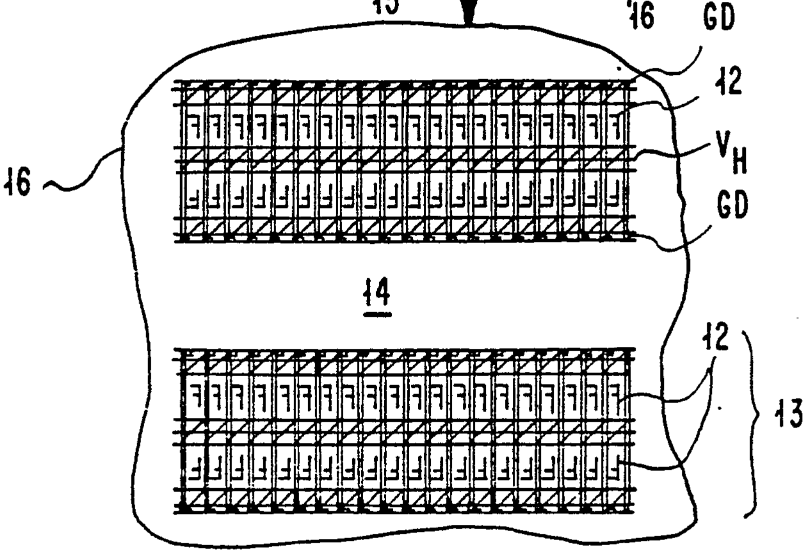

FIG.3A

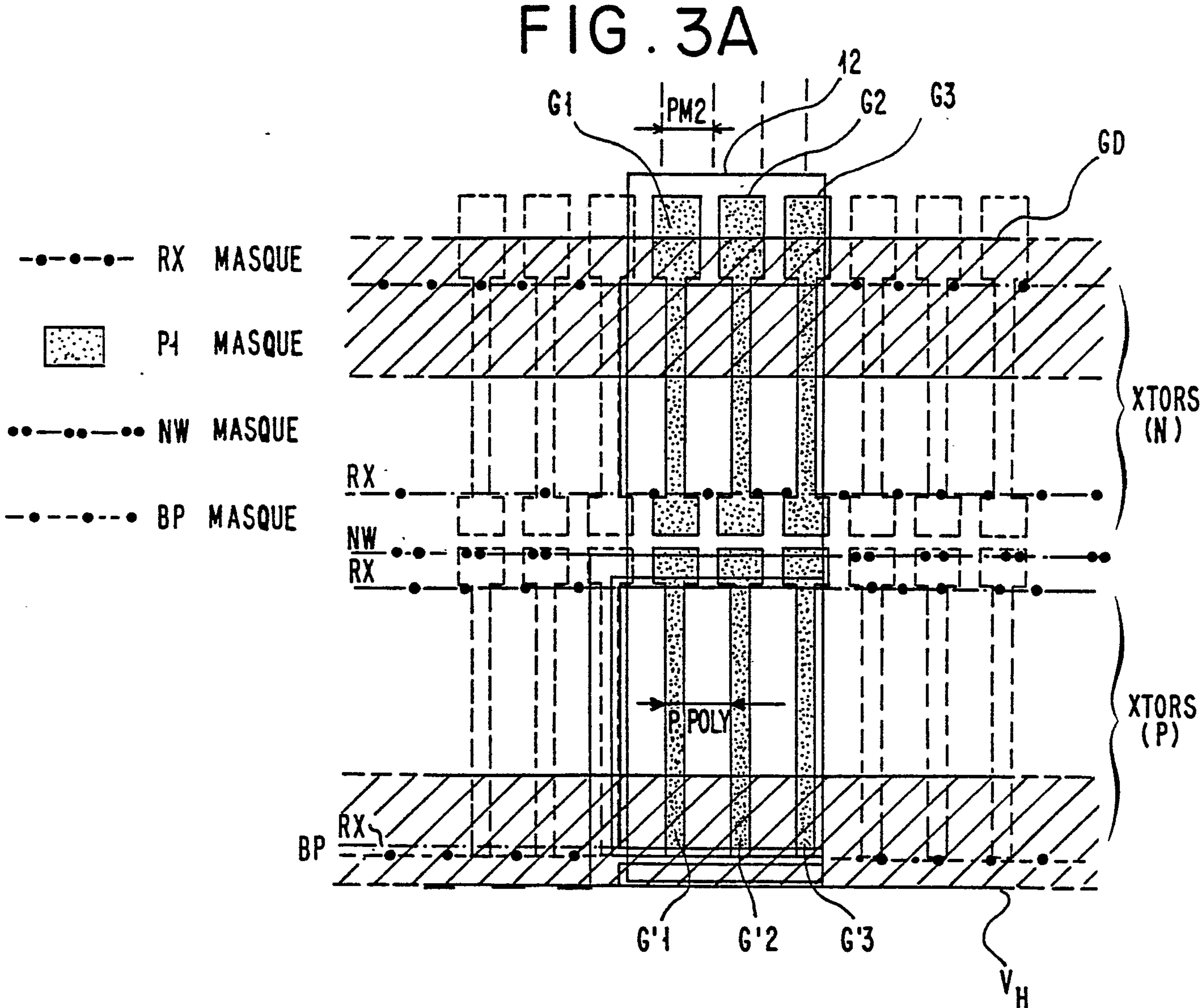
12
G1
PM2
G2
G3
GD
RX MASQUE
P1 MASQUE
NW MASQUE
BP MASQUE
XTORS (N)
RX
NW
RX
XTORS (P)
P POLY
BP
RX
G'1
G'2
G'3
$V_H$

FIG.3B

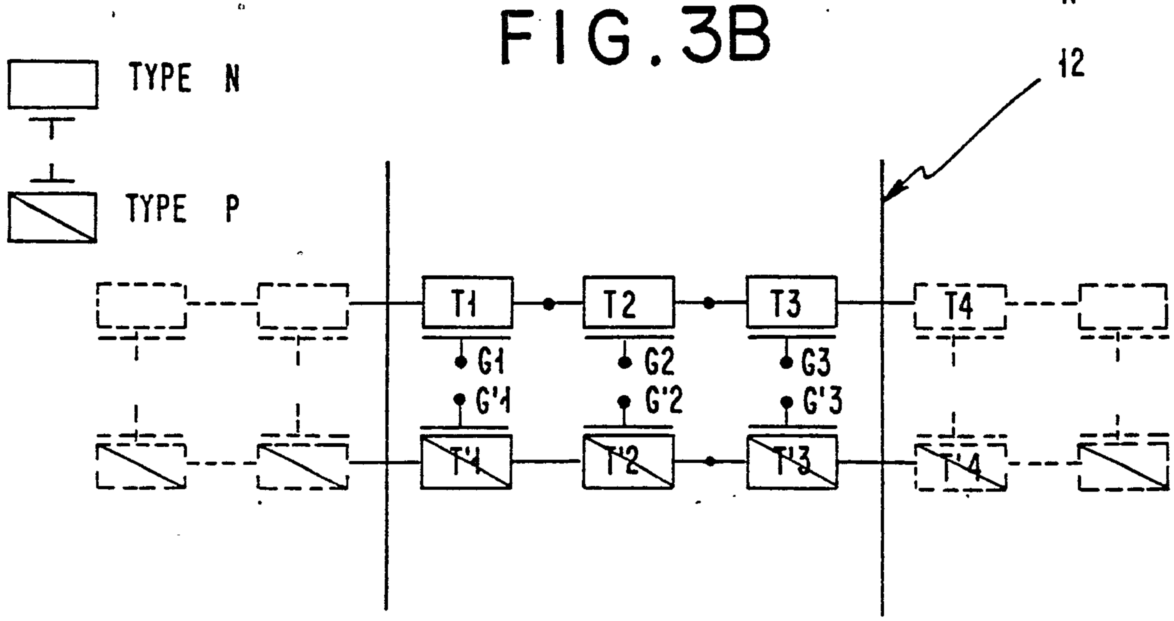
TYPE N
TYPE P
12
T1
T2
T3
T4
G1
G2
G3
G'1
G'2
G'3
T'1
T'2
T'3
T'4

FIG. 4A

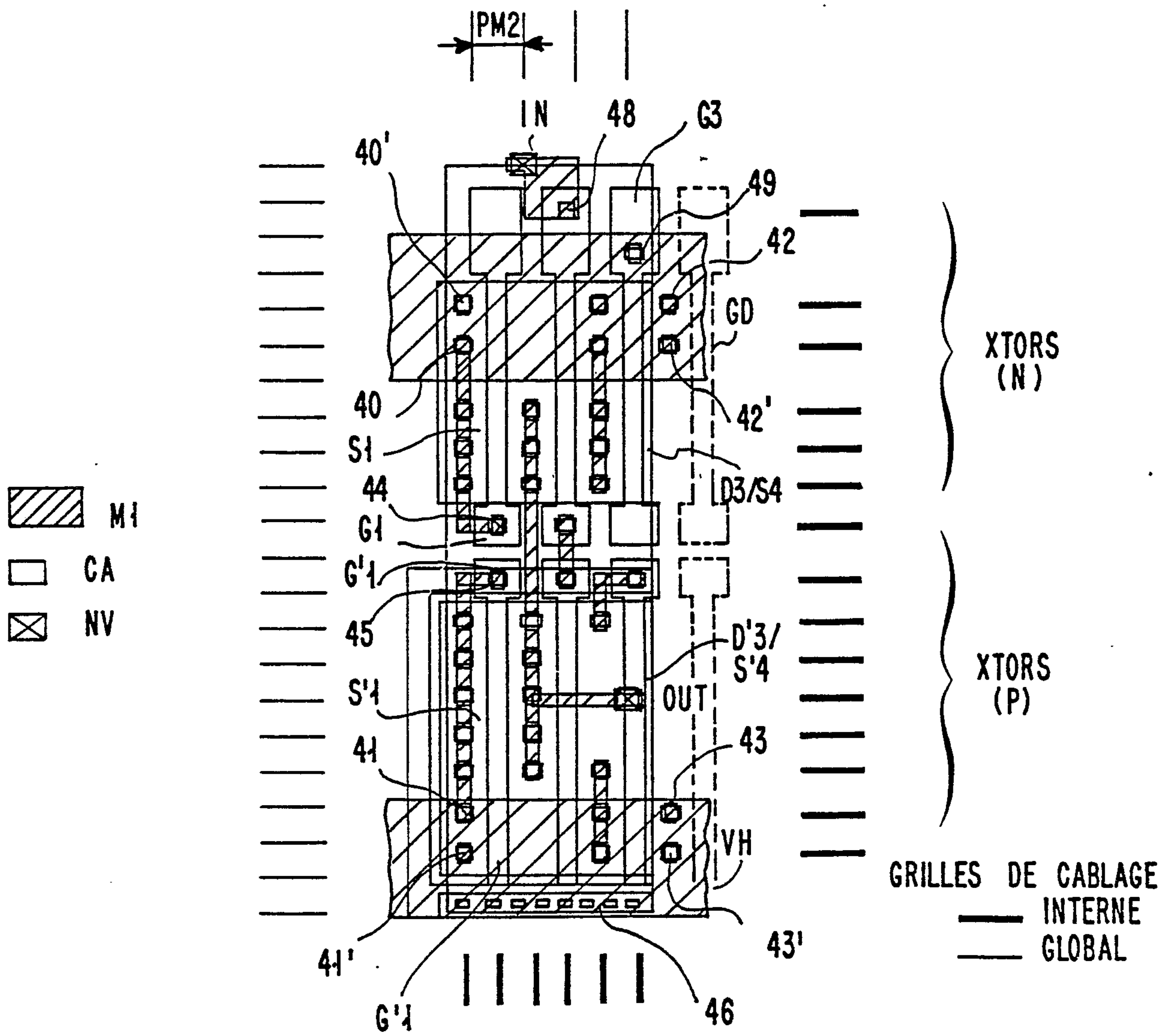
PM2
IN
48
G3
40'
49
42
GD
42'
40
S1
D3/S4
44
G1
G'1
45
D'3/
S'4
OUT
S'1
41
43
VH
41'
43'
G'1
46
M1
CA
NV
XTORS
(N)
XTORS
(P)
GRILLES DE CABLAGE
INTERNE
GLOBAL

FIG. 4B

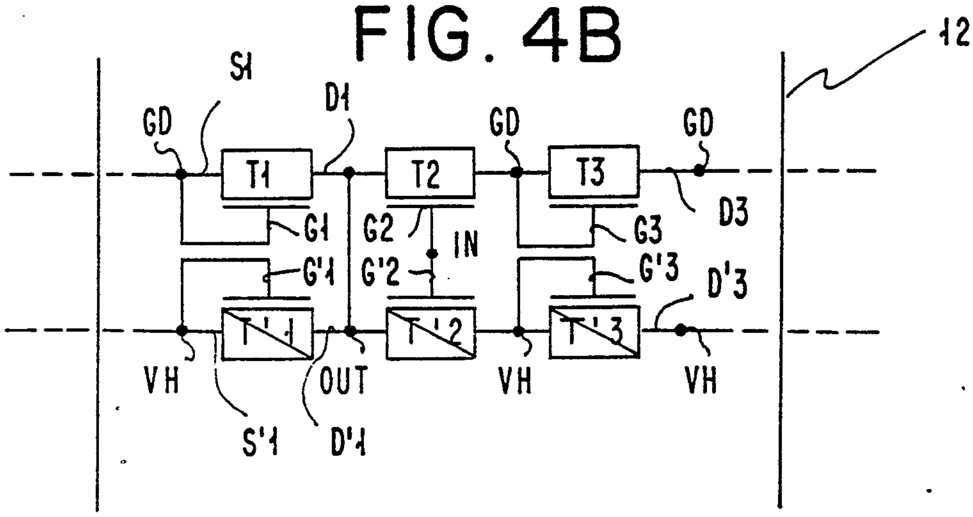
12
S1
D1
GD
GD
GD
T1
T2
T3
D3
G1
G2
G3
IN
G'1
G'2
G'3
D'3
T'1
T'2
T'3
VH
OUT
VH
VH
S'1
D'1

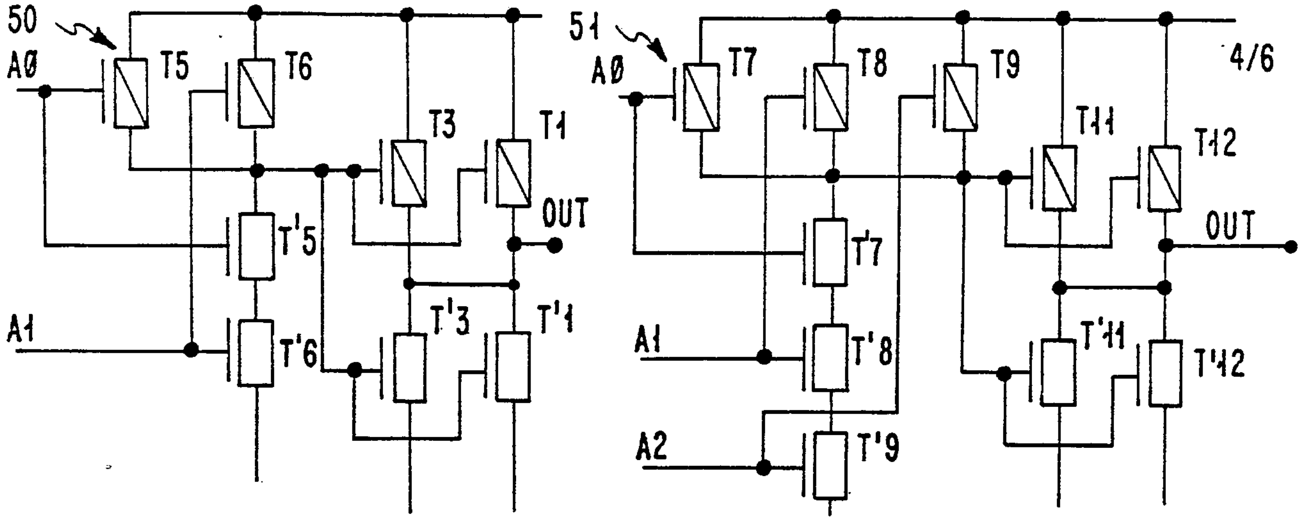
50
51
AØ
A1
A2
T5
T6
T3
T1
T'5
T'6
T'3
T'1
OUT
T7
T8
T9
T11
T12
T'7
T'8
T'9
T'11
T'12

FIG. 5B

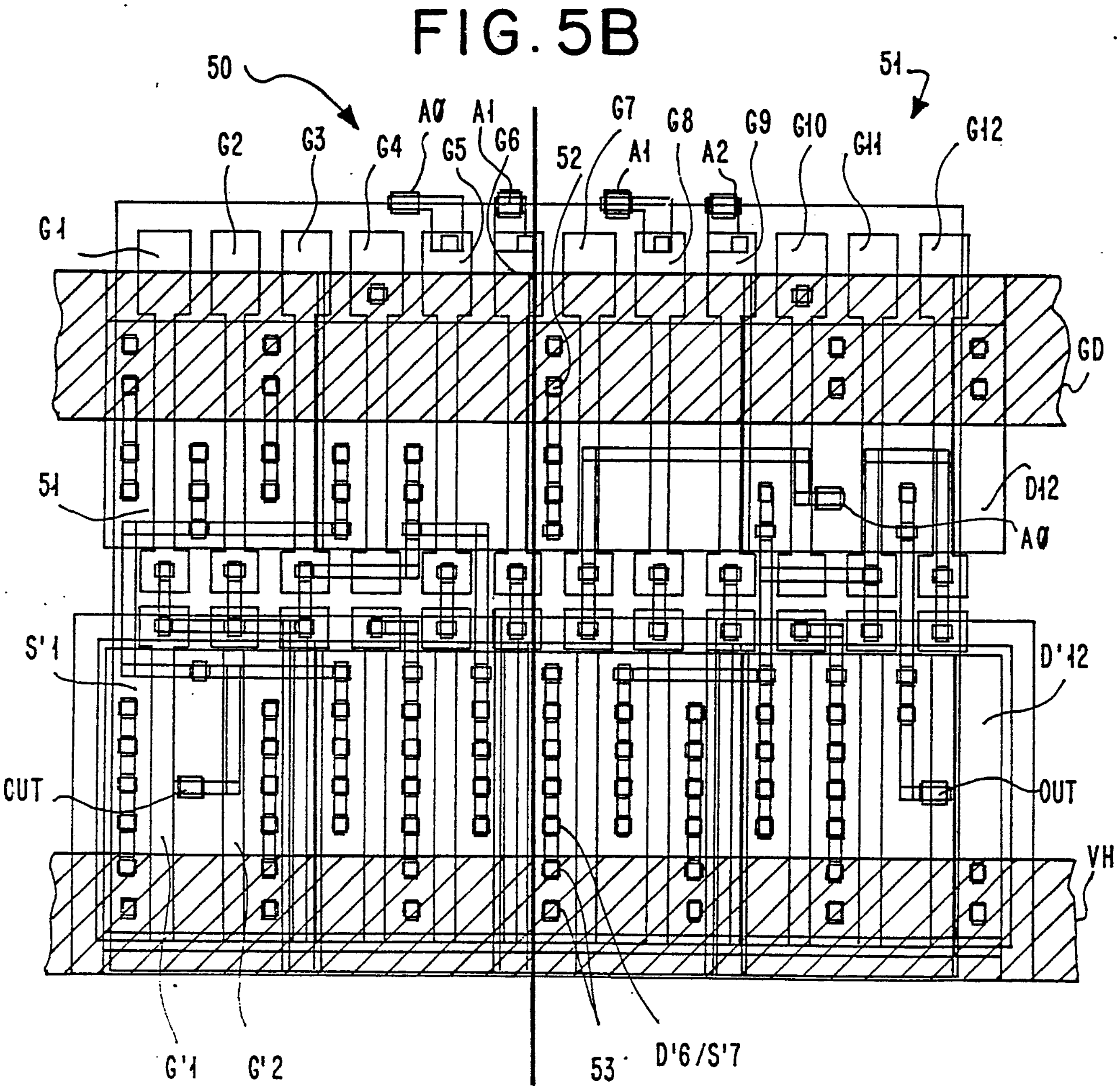
50
51
AØ
A1
A2
G1
G2
G3
G4
G5
G6
G7
G8
G9
G10
G11
G12
52
GD
D12
S'1
D'12
OUT
VH
G'1
G'2
53
D'6/S'7

FIG. 5A

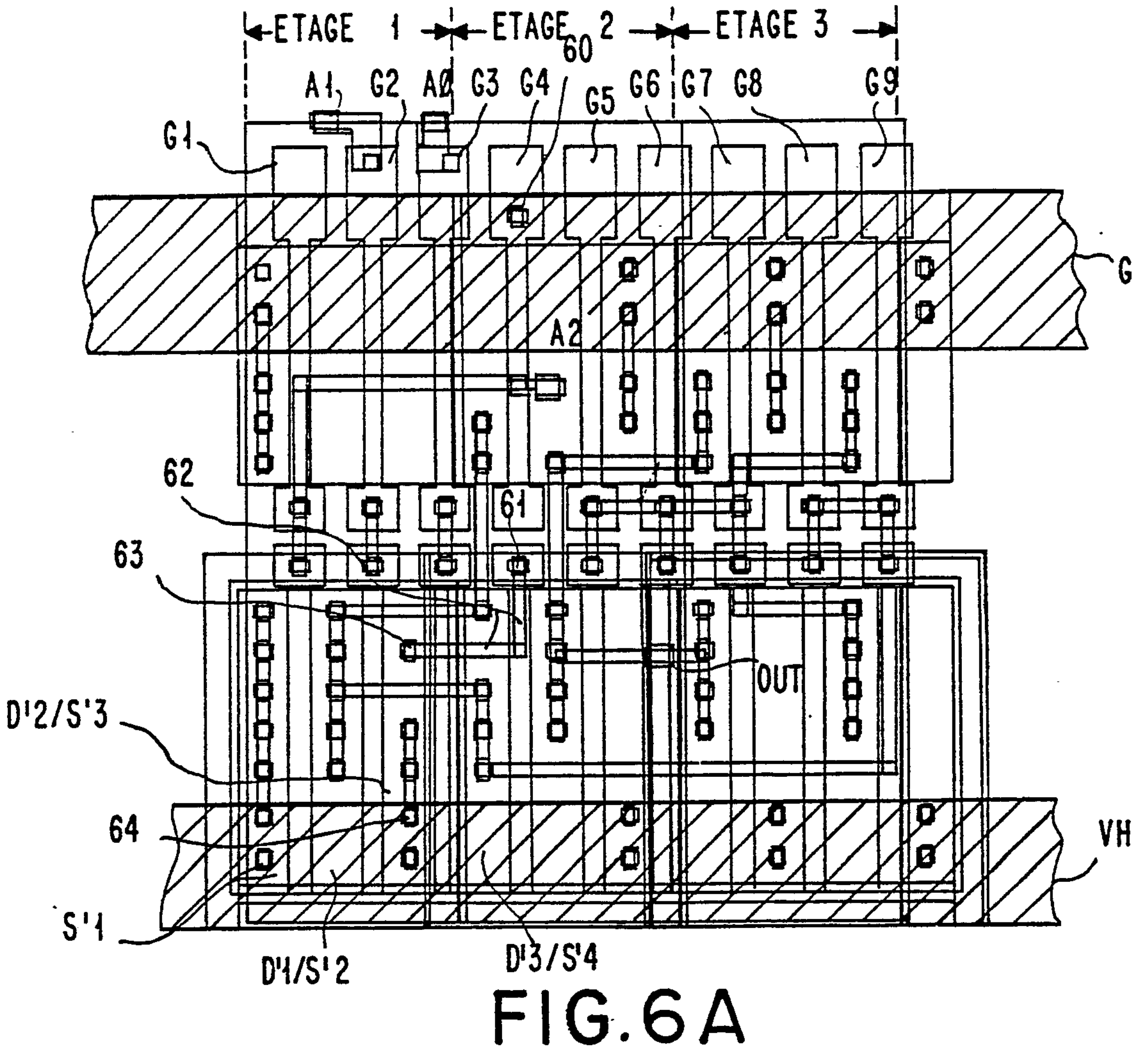
ETAGE 1
ETAGE 2
ETAGE 3
60
A1
G2
AØ
G3
G4
G5
G6
G7
G8
G9
G1
GD
A2
62
61
63
OUT
D'2/S'3
64
VH
S'1
D'1/S'2
D'3/S'4

FIG.6A

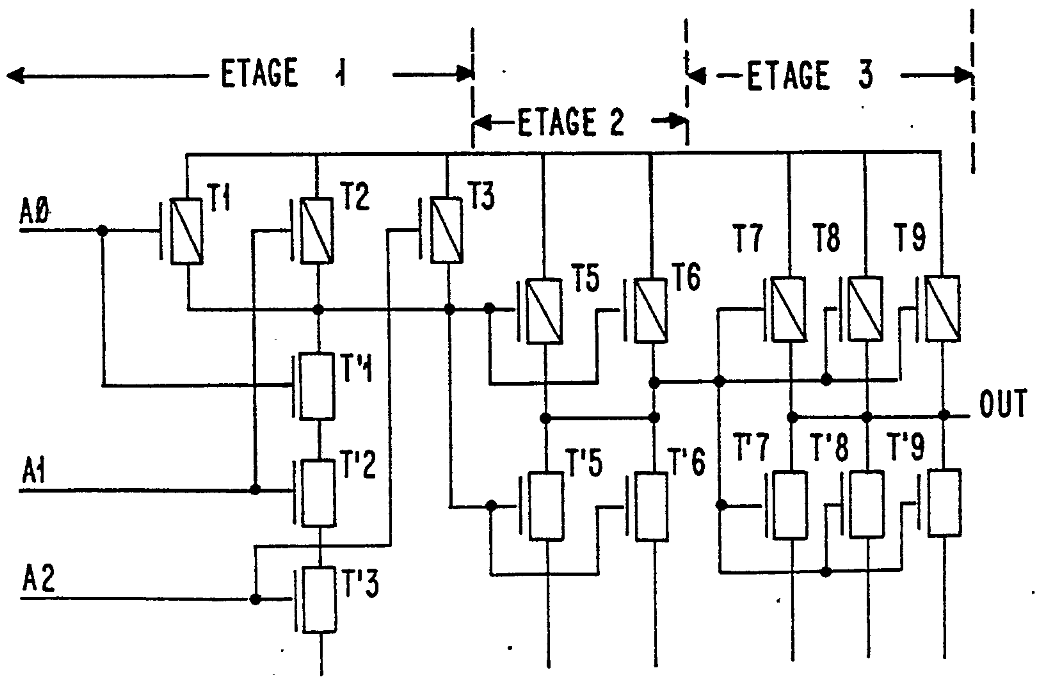
ETAGE 1
ETAGE 2
ETAGE 3
AØ
T1
T2
T3
T5
T6
T7
T8
T9
T'1
OUT
A1
T'2
T'5
T'6
T'7
T'8
T'9
A2
T'3

FIG.6B

FIG.7A

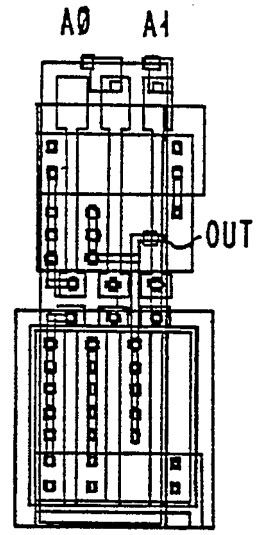


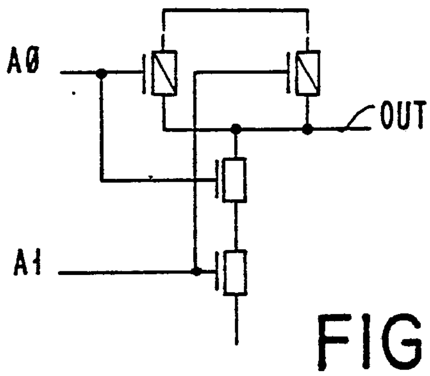


FIG.7B

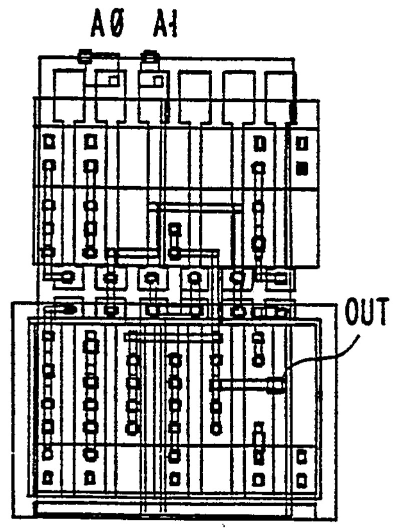


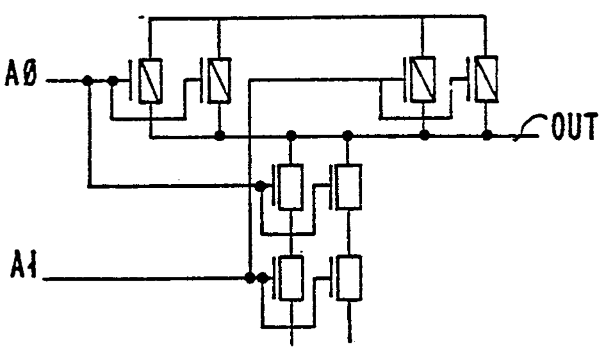


FIG.7C